(19) **Europäisches Patentamt / European Patent Office / Office européen des brevets**

(11) **EP 4 723 118 A1**

(12) # EUROPEAN PATENT APPLICATION
published in accordance with Art. 153(4) EPC

(43) Date of publication:
08.04.2026 Bulletin 2026/15

(21) Application number: 24930390.0

(22) Date of filing: 27.09.2024

(51) International Patent Classification (IPC):
*G11C 16/08* (2006.01)    *G11C 16/24* (2006.01)

(86) International application number:
PCT/CN2024/121762

(87) International publication number:
WO 2025/194731 (25.09.2025 Gazette 2025/39)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 20.03.2024 CN 202410317881

(71) Applicant: Beijing Superstring Academy of
Memory Technology
Beijing 100176 (CN)

(72) Inventor: DAI, Jin
Beijing 100176 (CN)

(74) Representative: Gulde & Partner
Patent- und Rechtsanwaltskanzlei mbB
Berliner Freiheit 2
10785 Berlin (DE)

(54) **STORAGE APPARATUS AND DATA READ METHOD THEREFOR, AND ELECTRONIC DEVICE**

(57) The present disclosure relates to a storage apparatus and a data read method therefor, and an electronic device. The storage apparatus comprises a plurality of storage units (U); word lines (WL), which extend in a first direction and are connected to first electrodes (11) of storage units (U) in corresponding rows; bit lines (BL), which extend in a second direction and are connected to second electrodes (12) of storage units (U) in corresponding columns; and a read/write controller (2), which is connected to the word lines (WL) and the bit lines (BL), and is configured to set the voltage of each word line (WL) to a first initial voltage, set the voltage of each bit line (BL) to a second initial voltage, set the voltage of a selected bit line (BL) to a first selected voltage, connect the selected bit line (BL) to an induction amplifier (24), and set the voltage of a selected word line (WL) to a second selected voltage, such that the induction amplifier (24) outputs a data read signal on the basis of whether charge transfer has occurred on the bit line (BL), wherein the data read signal is used for representing data stored in the storage units (U).

FIG. 1

EP 4 723 118 A1

# Description

## CROSS-REFERENCE TO RELATED APPLICATIONS

The present disclosure is the national phase of PCT/CN2024/121762 filed on September 27, 2024, and claims priority to Chinese Patent Application No. 202410317881.3, filed to the CNIPA on March 20, 2024, entitled "STORAGE APPARATUS, METHOD OF DATA READING FOR THE STORAGE APPARATUS, AND ELECTRONIC DEVICE", the disclosure of which is hereby incorporated by reference in its entirety.

## TECHNICAL FIELD

The present disclosure relates to the technical field of storage, and in particular to a storage apparatus, a Method of Data Reading for the Storage Apparatus, and an electronic device.

## BACKGROUND

With the development of communication technology and digital technology, people continue to pursue products with lower power consumption, lighter weight and better performance. As memory devices capable of storing information, storage apparatuses, such as Random Access Memories (RAMs), Magnetic Disks and Flash Memories, have been widely applied in electronic devices.

## SUMMARY

In accordance with some embodiments, in one aspect, the present disclosure provides a storage apparatus, comprising a memory unit array, a plurality of word lines, a plurality of bit lines and a read/write controller. The memory unit array comprises a plurality of memory units that are arranged in rows in a first direction and arranged in columns in a second direction. The memory units include first electrodes, second electrodes and dielectric layers disposed between the first electrodes and the second electrodes. The first direction intersects with the second direction. The word lines extend in the first direction and are connected to the first electrodes of the memory units in corresponding rows. The bit lines extend in the second direction and are connected to the second electrodes of the memory units in corresponding columns. The read/write controller is connected to the words lines and the bit lines, and is configured to: set the voltage of each word line to a first initial voltage, and set the voltage of each bit line to a second initial voltage; set the voltage of the selected bit line to a first selected voltage, and connect the selected bit line to a sense amplifier; and set the voltage of the selected word line to a second selected voltage, such that the sense amplifier outputs a data read signal on the basis of whether charge transfer has occurred in charges on the bit line, wherein the data read signal is used for representing data stored in the memory units.

In accordance with some embodiments, the read/write controller is further configured to: execute a recovery write operation on the memory units, after charge transfer has occurred in the charges on the bit line and the sense amplifier outputs the data read signal, so as to recover the read data in the memory units.

In accordance with some embodiments, the memory units include ferroelectric memory units, and the dielectric layers include ferroelectric dielectric layers.

In accordance with some embodiments, the read/write controller includes a control module, a word line selection circuit, a bit line selection circuit and a sense amplifier. The word line selection circuit connects the control module and each of the word lines and is configured to: provide the first initial voltage to each of the word lines in response to a first control command from the control module, and provide the second selected voltage to the selected word line in response to a third control command from the control module. The bit line selection circuit connects the control module to each of the bit lines and is configured to: provide the second initial voltage to each bit line in response to the first control command from the control module, and provide the first selected voltage to the selected bit line in response to a second control command from the control module. The sense amplifier connects the control module to the bit line selection circuit and is configured to: connect the selected bit line in response to the second control command from the control module, and output the data read signal after the voltage of the selected word line is set to the second selected voltage. The first control command, the second control command and the third control command are generated sequentially.

In accordance with some embodiments, the sense amplifier includes a charge integrator and a secondary amplifier. The charge integrator is configured to: after the selected bit line is connected, measure total amount of charge flowing into or out of the selected bit line at the first selected voltage, and convert the total amount of charge into a voltage signal as an initial read signal. The secondary amplifier is connected to an output end of the charge integrator and configured to: compare the initial read signal with a reference signal, and output the data read signal according to a result of comparison between the initial read signal and the reference signal.

In accordance with some embodiment, the charge integrator includes an operational amplifier and a feedback capacitor. The operational amplifier has a first input end, a second input end and an output end; the first input end is connected to a preset voltage end; the second input end is configured to connect the selected bit line and is pre-charged to a preset voltage in a data read stage; and, the output end is configured to output the initial read signal in the data read stage. The feedback capacitor has a first electrode and a second electrode; the first electrode of the feedback capacitor is connected to the second input end of the operational amplifier; and, the second electrode of the feedback capacitor is connected to the output end of the operational amplifier.

In accordance with some embodiments, the preset voltage to which the second input end is precharged is the same as a preset voltage of the preset voltage end connected to the first input end.

In accordance with some embodiments, the preset voltage to which the second input end is precharged is the first selected voltage.

In accordance with some embodiments, the second input end is connected to the selected bit line through the bit line selection circuit.

In accordance with some embodiments, the secondary amplifier includes a latch amplifier.

In accordance with some embodiments, the second selected voltage is a reference voltage.

Correspondingly, in some examples, the first initial voltage is a sum of the reference voltage and two thirds of a rated voltage, the second initial voltage is a sum of the reference voltage and one third of the rated voltage, and the first selected voltage is a sum of the reference voltage and the rated voltage.

Correspondingly, in other examples, the first initial voltage is the difference obtained by subtracting two thirds of a rated voltage from the reference voltage, the second initial voltage is the difference obtained by subtracting one third of the rated voltage from the reference voltage, and the first selected voltage is the difference obtained by subtracting the rated voltage from the reference voltage.

In accordance with some embodiments, the rated voltage includes a maximum power supply voltage.

In accordance with some embodiments, in another aspect, the present disclosure further provides a method of data reading for a storage apparatus, which is applied to the storage apparatus described in any one of the above embodiments. The method of data reading includes the following steps of:

Setting a voltage of each of the word lines to a first initial voltage, and setting a voltage of each of the bit lines to a second initial voltage.

Setting a voltage of the selected bit line to a first selected voltage, and connecting the selected bit line to a sense amplifier.

Setting the voltage of the selected word line to a second selected voltage.

Outputting, by the sense amplifier, a data read signal on the basis of whether charge transfer has occurred in charges on the bit line, wherein the data read signal is used for representing data stored in the memory units

In accordance with some embodiments, the method of data reading for a storage apparatus further includes: executing a recovery write operation on the memory units, after charge transfer has occurred in the charges on the bit line and the sense amplifier outputs the data read signal, so as to recover the read data in the memory units.

In accordance with some embodiments, the method of data reading for a storage apparatus further includes: initializing the sense amplifier while connecting the selected bit line to the sense amplifier.

In accordance with some embodiments, the sense amplifier includes a charge integrator and a secondary amplifier connected to an output end of the charge integrator. The outputting, by the sense amplifier, a data read signal on the basis of whether charge transfer has occurred in charges on the bit line includes: measuring, by the charge integrator, a total amount of charge flowing into or out of the bit line at the first selected voltage and converting the total amount of charge into a voltage signal as an initial read signal, after connecting the selected bit line; and comparing, by the secondary amplifier, the initial read signal with a reference signal, and outputting the data read signal according to a result of comparison between the initial read signal and the reference signal .

In accordance with some embodiments, the initializing the sense amplifier includes: pre-charging the charge integrator.

Correspondingly, when the voltage of the selected word line is set to the second selected voltage, the method of data reading further includes: disconnecting a pre-charging circuit of the charge integrator.

In accordance with some embodiments, the second selected voltage is a reference voltage.

Correspondingly, in some examples, the first initial voltage is a sum of the reference voltage and two thirds of a rated voltage, the second initial voltage is a sum of the reference voltage and one third of the rated voltage, and the first selected voltage is a sum of the reference voltage and the rated voltage.

Correspondingly, in other examples, the first initial voltage is a difference obtained by subtracting two thirds of a rated voltage from the reference voltage and, the second initial voltage is a difference obtained by subtracting one third of the rated voltage from the reference voltage, and the first selected voltage is a difference obtained by subtracting the rated voltage from the reference voltage.

In accordance with some embodiments, the rated voltage includes a maximum power supply voltage.

In accordance with some embodiments, in still another aspect, the present disclosure further provides an electronic device, including the storage apparatus described in any one of the above embodiments.

Details of one or more embodiments of the present disclosure will be set forth in the following drawings and description. Other features, objects and advantages of the present disclosure will become apparent from the specification, drawings and claims.

**BRIEF DESCRIPTION OF THE DRAWINGS**

The accompanying drawings to be used in the description of the embodiments will be briefly described below, in order to describe the technical solutions of the embodiments of the present disclosure more clearly. Obviously, the drawings described below are only some of the embodiments of the present disclosure, and a person of ordinary skill in the art can obtain other drawings based on these accompanying drawings without any creative effort.

FIG. 1 is a schematic structure diagram of a storage apparatus according to some embodiments of the present disclosure;
FIG. 2 is a schematic structure diagram of a sense amplifier according to some embodiments of the present disclosure;
FIG. 3 is a schematic structure diagram of a charge integrator according to some embodiments of the present disclosure;
FIG. 4 is a schematic flowchart of a method of date reading for a storage apparatus according to some embodiments of the present disclosure;
FIG. 5 is a schematic flowchart of another method of date reading for a storage apparatus according to some embodiments of the present disclosure; and
FIG. 6 is a schematic diagram of step S400 according to some embodiments of the present disclosure.

## DETAILED DESCRIPTION

To facilitate understanding of the present disclosure, the present disclosure will be described more completely below with reference to the accompanying drawings. The embodiments of the present disclosure are shown in the drawings. However, the present disclosure may be implemented in many different forms and is not limited to the embodiments described herein. Rather, these embodiments are provided so that the present disclosure will be thorough and complete.

Unless otherwise defined, all technical and scientific terms used herein have the same meaning as commonly understood by one of ordinary skill in the art to which the present disclosure belongs. The terminology used herein is for the purpose of describing particular embodiments only and is not intended to limit the present disclosure.

The "embodiment" mentioned herein means that the particular features, structures or characteristics described with reference to the embodiment may be included in at least one embodiment of the present disclosure. The presence of this phase in various places of the specification neither necessarily means the same embodiment, nor means an independent or alternative embodiment that is mutually exclusive with other embodiments. It should be explicitly and implicitly understood by those skilled in the art that the embodiments described herein may be combined with other embodiments.

It should be understood that the terms "first", "second", etc. used in the present application may be used herein to describe various elements, but these elements are not limited by these terms. These terms are only used to distinguish a first element from another element. For example, without departing from the scope of the present application, the first electrode may be referred to as a second electrode, and similarly, the second electrode may be referred to as a first electrode. Both the first electrode and the second electrode are electrodes, but they are not the same electrode.

It should be understood that "coupling" and "connection/connecting" in the following embodiments should be interpreted as "electrical connection/connecting", "communicative connection/connecting" or the like if there are signals or data transferred between the coupled or connected circuits, modules, units, etc.

As used herein, unless otherwise indicated clearly in the context, the singular forms "a", "an", and "the/said" may also include the plural forms. It should also be understood that the term "comprise/include" or "have" specifies the presence of the stated feature, integer, step, operation, component, part or combinations thereof, but the presence or addition of one or more other features, integers, steps, operations, components, parts or combinations thereof is not excluded. Meanwhile, as used herein, the term "and/or" includes any and all combinations of the associated listed items.

Semiconductor storage apparatus are storage apparatuses realized based on semiconductor materials such as silicon (Si), germanium (Ge), gallium arsenide (GaAs) or indium phosphide (InP). Semiconductor storage apparatus may be mainly classified into volatile storage apparatuses and nonvolatile storage apparatuses. The volatile storage apparatuses are storage apparatuses in which the data stored therein will be lost when the power is cut off. The volatile storage apparatuses include, for example, static random access memory (SRAM), dynamic random access memory (DRAM) and synchronous dynamic random access memory (SDRAM). The nonvolatile storage apparatuses are storage apparatus that can keep the data stored therein even when the power is cut off. The nonvolatile storage apparatuses include, for example, read-only memory (ROM), programmable read-only memory (PROM), electrically programmable read-only memory (EPROM), electrically erasable programmable read-only memory (EEPROM), NAND flash, NOR flash, phase-change random access memory (PRAM), magnetic random access memory (MRAM), resistive random access memory (RRAM), ferroelectric random access memory (FRAM), etc.

In some embodiments, taking ferroelectric random access memory as an example, the ferroelectric random access memory mainly realizes nonvolatile storage by applying a voltage to change the polarization direction of the ferroelectric medium in the capacitor. Therefore, reading data from the ferroelectric random access memory is generally read destructively. That is, by applying an enough high voltage to the capacitor, if the polarization direction of the ferroelectric medium is opposite to the voltage direction, the polarization direction of the ferroelectric medium will be reversed, so that an instantaneous current will be generated for charge transfer, and the stored data in the ferroelectric random access memory is read accordingly; and, if the polarization direction of the ferroelectric medium is reversed, a reverse voltage also needs to be applied to recover the destroyed stored data after completion of data reading.

On this basis, in a ferroelectric memory unit with a select transistor, for example in a memory unit with a single transistor and a single ferroelectric capacitor (1T1C), the transistor in the ferroelectric memory unit may be turned on through a word line to realize a read operation after the data read circuit is connected. However, in a ferroelectric memory unit without a select transistor, for example, in a memory unit with zero transistor and a single ferroelectric capacitor (0T1C), how to arrange the time sequence to ensure that the polarization reversion of the ferroelectric medium in the ferroelectric memory unit can be effectively detected without affecting unselected ferroelectric memory unit is a problem to be solved.

Hence, the embodiments of the present disclosure provide a storage apparatus, a method of date reading for the storage apparatus, and an electronic device, which can ensure and improve accuracy for the reading of stored data without select transistors and effectively improve the performance of storage apparatuses and electronic devices.

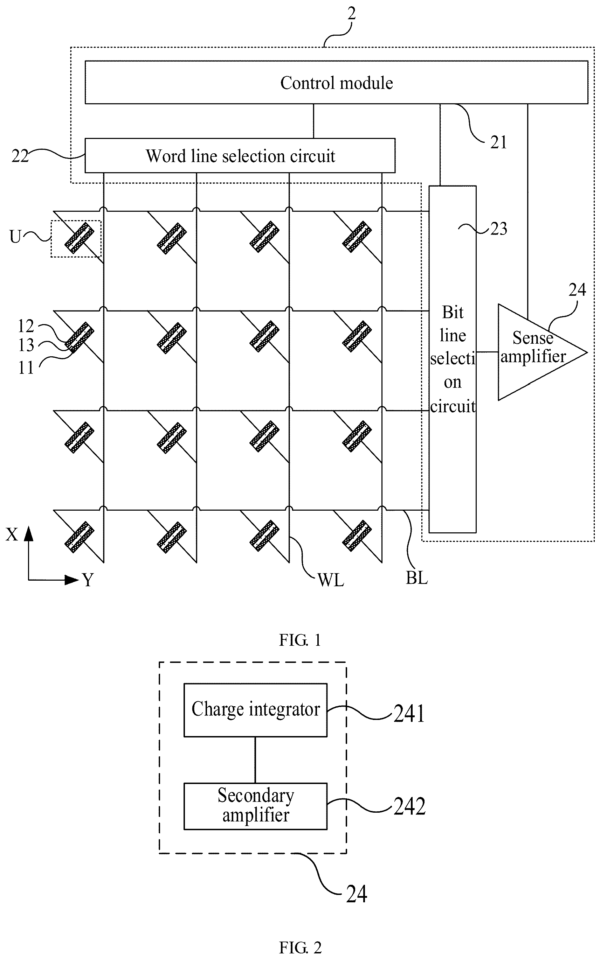

With reference to FIG. 1, the storage apparatus according to the embodiments of the present disclosure includes a memory unit array, a plurality of word lines WL, a plurality of bit lines BL and a read/write controller 2. The memory unit array includes a plurality of memory units U that are arranged in rows in a first direction (e.g., X direction) and arranged in columns in a second direction (e.g., Y direction). The first direction (e.g., X direction) intersects with, e.g., being orthogonal to, the second direction (e.g., Y direction). The memory units U include first electrodes 11, second electrodes 12, and dielectric layers 13 disposed between the first electrodes 11 and the second electrodes 12. That is, the memory units U mentioned in the embodiments of the present disclosure are memory units with zero transistor and a single capacitor (0T1C).

As an example, the memory units U are ferroelectric memory units, and the dielectric layers 13 are ferroelectric dielectric layers.

As an example, the material for the first electrodes 11 and the second electrodes 12 include metals, such as titanium, titanium nitride, tantalum nitride, platinum, copper, tungsten, titanium tungsten, tungsten nitride and/or ruthenium, and other conductive materials and/or combinations thereof.

As an example, the material for the ferroelectric dielectric layers includes, but not limited to, hafnium zirconium oxide (HfZrO, also referred to as HZO, containing hafnium, zirconium and oxygen), Si-doped hafnium oxide (a material containing hafnium, oxygen and silicon), Ge-doped hafnium oxide (a material containing hafnium, oxygen and germanium), Al-doped hafnium oxide (a material containing hafnium, oxygen and aluminum), Y-doped hafnium oxide (a material containing hafnium, oxygen and yttrium), lead zirconate titanate (a hafnium-containing material, containing lead, zirconium and titanium), barium zirconate titanate (a material containing barium, zirconium and titanium) and combinations thereof.

As an example, both the first direction (e.g., X direction) and the second direction (e.g., Y direction) are parallel to the substrate. The plurality of memory units U included in the memory unit array can not only be distributed in a two-dimensional single layer in the first direction (e.g., X direction) and the second direction (e.g., Y direction) aforesaid, but also be stacked in a third direction (e.g., Z direction, not shown in FIG. 1) perpendicular to the substrate to present a three-dimensional multilayer distribution.

As an example, as shown in FIG. 1, the first direction (e.g., X direction) and the second direction (e.g., Y direction) are parallel to the substrate and orthogonal to each other. One memory unit U is provided at the intersection of the orthogonal projections of any word line WL and each bit line BL in the third direction perpendicular to the substrate, respectively.

In some embodiments of the present disclosure, with continued reference to FIG. 1, the word lines WL extend in the first direction (e.g., X direction) and are connected to the first electrodes 11 of the memory units U in corresponding rows. The bit lines BL extend in the second direction (e.g., Y direction) and are connected to the second electrodes 12 of the memory units U in corresponding columns. The read/write controller 2 is connected to the words lines WL and the bit lines BL, and is configured to: set the voltage of each word line WL to a first initial voltage, and set the voltage of each bit line BL to a second initial voltage; set the voltage of the selected bit line BL to a first selected voltage, and connect the selected bit line BL to a sense amplifier 24; and set the voltage of the selected word line WL to a second selected voltage, such that the sense amplifier 24 outputs a data read signal on the basis of whether charge transfer has occurred on the bit line BL, wherein the data read signal is used for representing data stored in the memory units U.

In the embodiments of the present disclosure, the memory unit array is constructed by using the memory units U without transistor, the bit lines WL are connected to the first electrodes 11 of the memory units U in corresponding rows, and the bit lines BL are connected to the second electrodes 12 of the memory units U in corresponding columns, so that it is unnecessary to provide and arrange select transistors in the memory units U, and it is advantageous for greatly improving the storage density. Moreover, in the embodiments of the present disclosure, by using the read/write controller 2 connected to the word lines WL and the bit lines BL, it is possible to firstly set the voltage of each word line WL to the first initial voltage, and the voltage of each bit line BL to the second initial voltage, then set the voltage the selected bit line BL to the first selected voltage and connect the selected bit line BL to the sense amplifier 24, and finally set the voltage of the selected word line WL to the second selected voltage, such that the sense amplifier 24 outputs a data read signal on the basis of whether charge transfer has occurred on the bit line BL. That is, in the embodiments of the present disclosure, the read/write controller 2 controls the time sequence of the voltage transmitted by each word line WL and each bit line BL, so that the data reading of the storage apparatus can be effectively realized, and the risk of data misreading or missed reading in the memory units U can be reduced. Thus, the embodiments of the present disclosure can ensure and improve the reading accuracy of stored data without select transistors and effectively improve the performance of storage apparatuses and electronic devices.

It should be understood that, when the memory units U are ferroelectric memory units, the dielectric layers 13 (i.e., ferroelectric material) in the ferroelectric memory units will present different polarization states when data "1" or "0" is written. For example, when data "1" is written, the dielectric layers 13 in the ferroelectric memory units are in a first polarization state; and, for example, when data "0" is written, the dielectric layers 13 in the ferroelectric memory units are in a second polarization state. The first polarization state of the dielectric layers 13 may be reversed to the second polarization state under the action of an external electric field, and the second polarization state of the dielectric layers 13 may be reversed to the first polarization state under the action of the external electric field. For example, the second polarization state is the initial polarization state of the ferroelectric material.

Correspondingly, the voltage difference between the second selected voltage and the first selected voltage may be used to reverse one polarization state of the dielectric layers 13 in the ferroelectric memory units while keep the other polarization state unchanged.

As an example, the voltage difference between the second selected voltage and the first selected voltage may be used to reverse the first polarization state of the dielectric layers 13 while keep the second polarization state of the dielectric layers 13 unchanged. Thus, after the first selected voltage is provided to the selected bit line BL and the second selected voltage is provided to the selected word line WL, if the data stored in the ferroelectric memory units is "1", the first polarization state of the dielectric layers 13 in the ferroelectric memory units may be reversed to the second polarization state; and, if the data stored in the ferroelectric memory units is "0", the second polarization state of the dielectric layers 13 in the ferroelectric memory units is kept unchanged.

Conversely, as an example, the voltage difference between the second selected voltage and the first selected voltage may be used to reverse the second polarization state of the dielectric layers 13 while keep the first polarization state of the dielectric layers 13 unchanged. Thus, after the first selected voltage is provided to the selected bit line BL and the second selected voltage is provided to the selected word line WL, if the data stored in the ferroelectric memory units is "0", the second polarization state of the dielectric layers 13 in the ferroelectric memory units may be reversed to the first polarization state; and, if the data stored in the ferroelectric memory units is "1", the first polarization state of the dielectric layers 13 in the ferroelectric memory units is kept unchanged.

It should be complemented that, in some embodiments, the read/write controller 2 is further controlled to: execute a recovery write operation on the memory units U to recover the read data in the memory units U, after charge transfer has occurred on the bit line BL and the sense amplifier 24 outputs the data read signal.

Here, it should be understood that, if charge transfer has occurred on the bit line BL, it means that the data originally written into the original memory units U has been lost in the reading process. In the embodiments of the present disclosure, a recovery write operation is executed on the memory units U, so that it is advantageous for the repeated reading of the stored data.

In some embodiments, with continued reference to FIG. 1, the read/write controller 2 includes a control module 21, a word line selection circuit 22, a bit line selection circuit 23 and a sense amplifier 24. The word line selection circuit 22 connects the control module 21 and each word line WL and is configured to: provide the first initial voltage to each word line WL in response to a first control command from the control module 21, and provide the second selected voltage to the selected word line WL in response to a third control command from the control module 21. The bit line selection circuit 23 connects the control module 21 and each the bit line BL and is configured to: provide the second initial voltage to each bit line BL in response to the first control command from the control module 21, and provide the first selected voltage to the selected bit line BL in response to a second control command from the control module 21. The sense amplifier 24 connects the control module 21 and the bit line selection circuit 23 and is configured to: connect the selected bit line BL in response to the second control command from the control module 21, and output the data read signal after the voltage of the selected word line WL is set to the second selected voltage. The first control command, the second control command and the third control command are generated sequentially.

As an example, the control module 21 includes, but not limited to, a logic control chip.

As an example, the word line selection circuit 22 and the bit line selection circuit 23 are arranged at the periphery of the memory unit array. For example, the word line selection circuit 22 and the bit line selection circuit 23 may be arranged on two sides (including two opposite sides or two adjacent sides) of the memory unit array. In the embodiments of the present disclosure, the circuit structures of the word line selection circuit 22 and the bit line selection circuit 23 will not be specifically limited as long as the above function can be realized. For example, the word line selection circuit 22 and the bit line selection circuit 23 may be formed by connecting multi-channel transistor transistors.

As an example, the sense amplifier 24 is initialized while connecting the selected bit line.

As an example, with reference to FIG. 2, the sense amplifier 24 includes a charge integrator 241 and a secondary amplifier 242. The charge integrator 241 is configured to: after connecting the selected bit line BL, measure the total amount of charge flowing into or out of the selected bit line BL at the first selected voltage, and convert the total amount of charge into a voltage signal as an initial read signal. Here, the first selected voltage is a stable voltage applied to the selected bit line BL, and the total amount of charge on the bit line BL may be effectively sensed after the second selected voltage is applied to the selected word line WL. The secondary amplifier 242 is connected to an output end of the charge integrator 241 and configured to: compare the initial read signal with a reference signal, and output a data read signal according to the result of comparison between the initial read signal and the reference signal.

In the embodiments of the present disclosure, it is provided with the charge integrator 241 and the secondary amplifier 242 in the sense amplifier 24, the initial read signal can be obtained by the charge integrator 242 through the selected bit line BL. That is, the charge integrator 241 may measure the total amount of charge flowing into or out of the selected bit line BL at the first selected voltage after connecting the selected bit line BL, and then convert the total amount of charge into a voltage signal (i.e., a read sensing signal) as the initial read signal. Then, in the embodiments of the present disclosure, the data read signal may be output according to the result of comparison between the initial read signal and the reference signal by the secondary amplifier 242 so as to read the data stored in the memory units U. Since no bit line BL is floating in the data read stage during the above data read process in the embodiments of the present disclosure, the charge change generated by the memory units U can be prevented from being shared by the parasitic capacitance of the bit line BL, the peripheral circuit and other related circuits (that is, the parasitic capacitance on the read path of the memory units U will not take in or take out the charge). Thus, no obvious voltage changes will be occurred on the read path of the selected bit line BL connected to the charge integrator 241 and the whole memory unit U, great attenuation or attenuation of the signal can be effectively prevented and it is advantageous to improve the accuracy of reading the stored data and the performance of storage apparatuses and electronic devices.

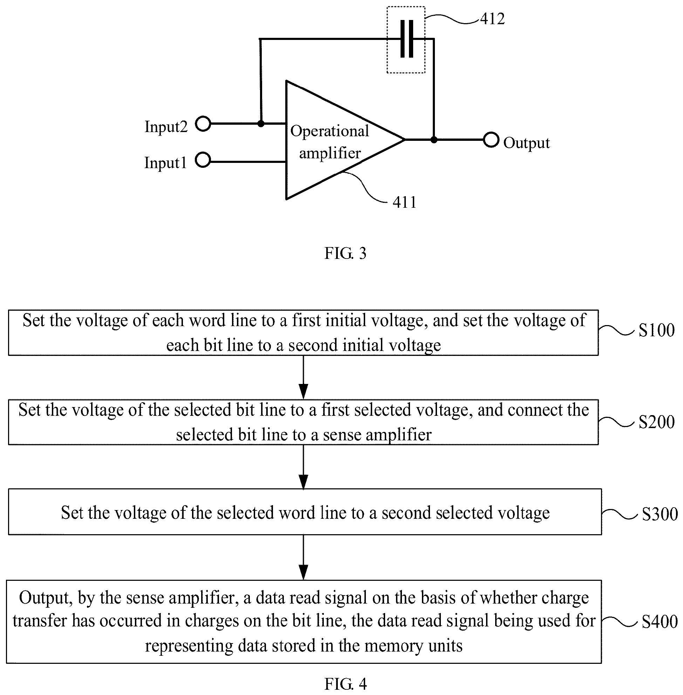

In some examples, with reference to FIG. 3, the charge integrator 241 includes an operational amplifier 411 and a feedback capacitor 412. The operational amplifier 411 has a first input end Input1, a second input end Input2 and an output end Output. The feedback capacitor 412 has a first electrode and a second electrode. The first electrode of the feedback capacitor 412 is connected to the second input end Input2 of the operational amplifier 411, and the second electrode of the feedback capacitor 412 is connected to the output end Output of the operational amplifier 411. The first input end Input 1 is connected to a preset voltage end; the second input end Input2 is configured to connect the selected bit line BL and is pre-charged to a preset voltage in the data read stage; and the output end Output is configured to output the initial read signal in the data read stage.

As an example, the preset voltage to which the second input end Input2 is pre-charged is the same as the preset voltage of the preset voltage end connected to the first input end Input1, and the operation of the operational amplifier 411 can substantially lock the voltage of the second input end Input2 to the preset voltage.

As an example, the preset voltage to which the second input end Input2 is pre-charged is the first selected voltage.

As an example, the second input end Input2 is connected to the selected bit line BL through the bit line selection circuit 23.

As an example, the initialization of the sense amplifier 24 is realized by the initialization of the charge integrator 241. The initialization of the charge integrator 241 may be manifested as pre-charging. That is, the initialization of the charge integrator 241 may be realized by the corresponding connected pre-charging circuit. Correspondingly, when the voltage of the selected word line WL is set to the second selected voltage, the pre-charging circuit of the charge integrator 241 is also required to be turn off. In the embodiments of the present disclosure, the circuit design of the pre-charging circuit will not be specifically limited as long as the above function can be realized. Optionally, the pre-charging circuit may be a switch device or other circuit structures connected to a voltage terminal of the power supply, and the voltage terminal of the power supply is used to provide the rated high-level voltage.

In some embodiments, the secondary amplifier 242 includes, but not limited to, a latch amplifier. The circuit of the secondary amplifier 242 is designed so that the data read signal can be effectively output according to the result of comparison between the initial read signal and the reference signal after the initial read signal is compared with the reference signal.

It should be complemented that, in some embodiments, the initial read signal output by the charge integrator 241 is a voltage signal. Correspondingly, a voltage threshold can be used as the reference signal for comparison with the initial read signal in the secondary amplifier 242. Thus, it is convenient for the secondary amplifier 242 to convert the initial read signal into a high level representing data "1" or a low level representing data "0" on the basis of whether the voltage of the initial read signal goes beyond the set voltage threshold thus facilitating the simplification of the circuit design of the secondary amplifier 242.

It is worth mentioning that the first initial voltage, the second initial voltage, the first selected voltage and the second selected voltage may be selected and set as required. The embodiments of the present disclosure exemplarily provide some possible implementations, but are not limited thereto.

In some embodiments, the second selected voltage provided to the selected word line WL is a reference voltage V1. Correspondingly, the first initial voltage, the second initial voltage and the first selected voltage may be set based on the reference voltage V1.

In some embodiments, the first initial voltage V2 is the sum of the reference voltage V1 and two thirds of the rated voltage Vdd, that is, $V2=V1+\frac{2}{3}Vdd$. The second initial voltage V3 is the sum of the reference voltage V1 and one third of the rated voltage Vdd, that is, $V3=V1+\frac{1}{3}Vdd$. The first selected voltage V4 is the sum of the reference voltage V1 and the rated voltage Vdd, that is, V4=V1+Vdd.

In other embodiments, the first initial voltage V2 is the difference obtained by subtracting two thirds of the rated voltage Vdd from the reference voltage V1, that is, $V2=V1-\frac{2}{3}Vdd$. The second initial voltage V3 is the difference obtained by subtracting one third of the rated voltage Vdd from the reference voltage V1, that is, $V3=V1-\frac{1}{3}Vdd$. The first selected voltage V4 is the difference obtained by subtracting the rated voltage Vdd from the reference voltage V1, that is, V4=V1-Vdd.

As an example, the rated voltage Vdd may be selected and set as required. For example, it may be a maximum power supply voltage.

In the embodiments of the present disclosure, the first initial voltage, the second initial voltage, the first selected voltage and the second selected voltage is taken as above schemes, so that the first initial voltage, the second initial voltage and the first selected voltage are in different voltage biasing states respectively when the second selected voltage is the reference voltage V1. Thus, it is advantageous to ensure that the selected memory unit U can have a relatively large read sensing margin, the voltage disturbance of the selected memory unit U to its neighboring memory units U is effectively reduced, and the data reading accuracy of the memory units U without select transistors is further improved.

Some embodiments of the present disclosure further provide a method of data reading for a storage apparatus, which can be applied to the storage apparatus described in any one of the above embodiments. The technical advantages of the above storage apparatus are also possessed by the method of data reading for a storage apparatus and will not be repeated here.

In some embodiments, with reference to FIG. 4, the method of data reading for a storage apparatus includes the following steps S100 to S400.

At S100, the voltage of each word line is set to a first initial voltage, and the voltage of each bit line is set to a second initial voltage.

At S200, the voltage of the selected bit line is set to a first selected voltage, and the selected bit line is connected to a sense amplifier.

At S300, the voltage of the selected word line is set to a second selected voltage.

At S400, the sense amplifier outputs a data read signal on the basis of whether charge transfer has occurred in charges on the bit line, the data read signal being used for representing data stored in the memory units.

As an example, the memory units are ferroelectric memory units.

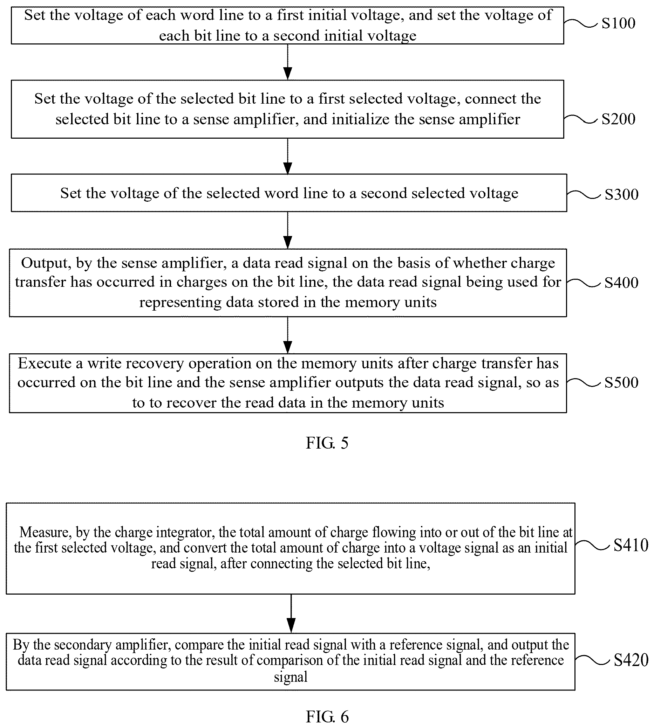

In some embodiments, with reference to FIG. 5, the method of data reading for a storage apparatus further includes a step S500.

At S500, a recovery write operation is executed on the memory units to recover the read data in the memory units, after charge transfer has occurred in charges on the bit line and the sense amplifier outputs the data read signal.

In the embodiments of the present disclosure, if charge transfer has occurred on in charges the bit line, it means that the data originally written into the memory units has been lost in the reading process. In the embodiments of the present disclosure, a recovery write operation is executed on the memory units, so that it is advantageous for the repeated reading of the stored data.

In some embodiments, with continued reference to FIG. 5, the step S200 further includes: initializing the sense amplifier while connecting the selected bit line to the sense amplifier.

Here, the initialization of the sense amplifier may refer to the above related records, and will not be repeated.

It is worth mentioning that the first initial voltage, the second initial voltage, the first selected voltage and the second selected voltage may be selected and set as required. The embodiments of the present disclosure exemplarily provide some possible implementations, but are not limited thereto.

In some embodiments, the second selected voltage provided to the selected word line WL is a reference voltage V1. Correspondingly, the first initial voltage, the second initial voltage and the first selected voltage may be set based on the reference voltage V1.

In some embodiments, the first initial voltage V2 is the sum of the reference voltage V1 and two thirds of the rated voltage Vdd, that is, $V2=V1+\dfrac{2}{3}Vdd$. The second initial voltage V3 is the sum of the reference voltage V1 and one third of the rated voltage Vdd, that is,

$$V3=V1+\dfrac{1}{3}Vdd$$

. The first selected voltage V4 is the sum of the reference voltage V1 and the rated voltage Vdd, that is, V4=V1+Vdd.

In other embodiments, the first initial voltage V2 is the difference obtained by subtracting two thirds of the rated voltage Vdd from the reference voltage V1, that is,

$$V2=V1-\dfrac{2}{3}Vdd$$

. The second initial voltage V3 is the difference obtained by subtracting one third of the rated voltage Vdd from the reference voltage V1, that is,

$$V3=V1-\dfrac{1}{3}Vdd$$

. The first selected voltage V4 is the difference obtained by subtracting the rated voltage Vdd from the reference voltage V1, that is, V4=V1-Vdd.

As an example, the rated voltage Vdd may be selected and set as required. For example, it may be a maximum power supply voltage.

In the embodiments of the present disclosure, the first initial voltage, the second initial voltage, the first selected voltage and the second selected voltage is taken as above schemes, so that the first initial voltage, the second initial voltage and the first selected voltage are in different voltage biasing states respectively when the second selected voltage is the reference voltage. Thus, it is advantageous to ensure that the selected memory unit U can have a relatively large read sensing margin, the voltage disturbance of the selected memory unit U to its neighboring memory units U is effectively reduced, and the data reading accuracy of the memory units U without select transistors is further improved.

It should be complemented that, in combination with FIGS. 2 and 6, in some embodiments, the sense amplifier 4 includes a charge integrator 241 and a secondary amplifier 242. Correspondingly, the step S400 may include the following steps S410 and S420.

At S410, after connecting the selected bit line, the charge integrator measure the total amount of charge flowing into or out of the bit line at the first selected voltage, and converts the total amount of charge into a voltage signal as an initial read signal.

At S420, the secondary amplifier compares the initial read signal with a reference signal, and outputs the data read signal according to the result of comparison between the initial read signal and the reference signal.

Here, the data read signal is used for representing data stored in the memory units U.

In the embodiments of the present disclosure, upon measuring the total amount of charge flowing into or out of the selected bit line at the first selected voltage, the charge integrator may use the voltage signal (i.e., read sensing signal) converted from the total amount of charge, as the initial read signal; and, the secondary comparator may output the data read signal according to the result of comparison of the initial read signal and the reference signal, to read the data stored in the memory units. Since no bit line is floating in the data read stage during the above data read process in the embodiments of the present disclosure, the charge change generated by the memory units can be prevented from being shared by the parasitic capacitance of the bit line, the peripheral circuit and other related circuits (that is, the parasitic capacitance on the read path of the memory units will not take in or take out the charge). Thus, no obvious voltage changes will be occurred on the read path of the selected bit line connected to the charge integrator and the whole memory unit, great attenuation or attenuation of the signal can be effectively prevented and it is advantageous to improve the accuracy of reading the stored data and the performance of storage apparatuses and electronic devices.

Some embodiments of the present disclosure further provide an electronic device, for example, a data storage device, a photocopier, a network device, a household appliance, an instrument, a mobile phone, a computer or other devices with a data storage function. The electronic device may include the storage apparatus described in the above some embodiments. The electronic device may further include other necessary elements or components, which is not limited in the embodiments of the present disclosure.

The technical features of the above embodiments may be combined arbitrarily. For the sake of brevity, not all possible combinations of the technical features of the above embodiments are described. However, the combinations of these technical features should be considered within the scope of this specification as long as they do not contradict each other.

The above embodiments only illustrate several implementations of the present disclosure. Their descriptions are relatively specific and detailed, but they should not be construed as limiting the patent scope of the present application. It should be noted that those skilled in the art can make several modifications and improvements without departing from the concept of the present disclosure, and these modifications and improvements all fall within the protection scope of the present disclosure. Therefore, the protection scope of the present disclosure shall be defined by the appended claims.

**Claims**

1. A storage apparatus, comprising:

a memory unit array, comprising a plurality of memory units that are arranged in rows in a first direction and arranged in columns in a second direction, the memory units comprising first electrodes, second electrodes and dielectric layers disposed between the first electrodes and the second electrodes, the first direction intersecting with the second direction;

a plurality of word lines extending in the first direction and are connected to the first electrodes of the memory units in corresponding rows;

a plurality of bit lines extending in the second direction and are connected to the second electrodes of the memory units in corresponding columns; and

a read/write controller connected to the word lines and the bit lines and configured to:

set a voltage of each word line to a first initial voltage, and set a voltage of each bit line to a second initial voltage;

set a voltage of a selected bit line to a first selected voltage, and connect the selected bit line to a sense amplifier; and

set a voltage of a selected word line to a second selected voltage, such that the sense amplifier outputs a data read signal on the basis of whether charge transfer has occurred in charges on the bit line, wherein the data read signal is used for representing data stored in the memory units.

2. The storage apparatus according to claim 1, wherein the read/write controller is further configured to: execute a recovery write operation on the memory units, after charge transfer has occurred in the charges on the bit line and the sense amplifier outputs the data read signal, so as to recover the read data in the memory units.

3. The storage apparatus according to claim 1, wherein the memory units comprise ferroelectric memory units, and the dielectric layers comprise ferroelectric dielectric layers.

4. The storage apparatus according to claim 1, wherein the read/write controller comprises:

a control module;

a word line selection circuit, which connects the control module and each of the word lines and is configured to: provide the first initial voltage to each of the word lines in response to a first control command from the control module, and provide the second selected voltage to the selected word line in response to a third control command from the control module;

a bit line selection circuit, which connects the control module and each of the bit lines and is configured to: provide the second initial voltage to each of the bit lines in response to the first control command from the control module, and provide the first selected voltage to the selected bit line in response to a second control command from the control module; and

a sense amplifier, which connects the control module and the bit line selection circuit and is configured to: connect the selected bit line in response to the second control command from the control module, and output the data read signal after the voltage of the selected word line is set to the second selected voltage;

wherein the first control command, the second control command and the third control command are generated sequentially.

5. The storage apparatus according to claim 4, wherein the sense amplifier comprises:

a charge integrator which is configured to: after the selected bit line is connected, measure total amount of charge flowing into or out of the bit line at the first selected voltage, and convert the total amount of charge into a voltage as an initial read signal; and

a secondary amplifier, which is connected to an output end of the charge integrator and is configured to: compare the initial read signal with a reference signal, and output the data read signal according to a result of comparison between the initial read signal and the reference signal.

6. The storage apparatus according to claim 5, wherein the charge integrator comprises:

an operational amplifier having a first input end, a second input end and an output end, the first input end being connected to a preset voltage end, the second input end being configured to connect the selected bit line and being precharged to a preset voltage during a data read stage, the output end being configured to output the initial read signal during the data read stage; and

a feedback capacitor having a first electrode and a second electrode, the first electrode of the feedback capacitor being connected to the second input end of the operational amplifier, the second electrode of the feedback capacitor being connected to the output end of the operational amplifier.

7. The storage apparatus according to claim 6, wherein the preset voltage to which the second input end is pre-charged is the same as a preset voltage of the preset voltage end connected to the first input end.

8. The storage apparatus according to claim 6, wherein the preset voltage to which the second input end is pre-charged is the first selected voltage.

9. The storage apparatus according to claim 6, wherein the second input end is connected to the selected bit line through the bit line selection circuit.

10. The storage apparatus according to claim 5, wherein the secondary amplifier comprises a latch amplifier.

11. The storage apparatus according to any one of claims 1 to 10, wherein the second selected voltage is a reference voltage, and wherein,

the first initial voltage is a sum of the reference voltage and two thirds of a rated voltage, the second initial voltage is a sum of the reference voltage and one third of the rated voltage, and the first selected voltage is a sum of the reference voltage and the rated voltage; or, the first initial voltage is a difference obtained by subtracting two thirds of a rated voltage from the reference voltage, the second initial voltage is a difference obtained by subtracting one third of the rated voltage from the reference voltage, and the first selected voltage is a difference obtained by subtracting the rated voltage from the reference voltage.

12. The storage apparatus according to claim 11, wherein the rate voltage comprises a maximum power supply voltage.

13. A method of data reading for a storage apparatus, which is applied to the storage apparatus according to any one of claims 1 to 12, wherein the method of data reading comprises steps of:

setting a voltage of each of the word lines to a first initial voltage, and setting a voltage of each of the bit lines to a second initial voltage; setting a voltage of the selected bit line to a first selected voltage, and connecting the selected bit line to a sense amplifier; setting the voltage of the selected word line to a second selected voltage; and outputting, by the sense amplifier, a data read signal on the basis of whether charge transfer has occurred in charges on the bit line, wherein the data read signal is used for representing data stored in the memory units.

14. The method of data reading for a storage apparatus according to claim 13, further comprising: executing a recovery write operation on the memory units, after charge transfer has occurred in the charges on the bit line and the sense amplifier outputs the data read signal, so as to recover the read data in the memory units.

15. The method of data reading for a storage apparatus according to claim 13, further comprising: initializing the sense amplifier while connecting the selected bit line to the sense amplifier.

16. The method of data reading for a storage apparatus according to claim 13, wherein the sense amplifier comprises: a charge integrator and a secondary amplifier connected to an output end of the charge integrator;
the outputting, by the sense amplifier, the data read signal on the basis of whether the charge transfer has occurred in the charges on the bit line comprises:

measuring , by the charge integrator, a total amount of charge flowing into or out of the bit line at the first selected voltage and converting the total amount of charge into a voltage signal as an initial read signal, after connecting the selected bit line; and comparing, by the secondary amplifier, the initial read signal with a reference signal, and outputting the data read signal according to a result of comparison between the initial read signal and the reference signal.

17. The method of data reading for a storage apparatus according to claim 16, wherein the initializing the sense amplifier comprises: pre-charging the charge integrator;
wherein, when the voltage of the selected word line is set to the second selected voltage, the method of data reading further comprises: disconnecting a pre-charging circuit of the charge integrator.

18. The method of data reading for a storage apparatus according to any one of claims 13 to 17, wherein the second selected voltage is a reference voltage, wherein,

the first initial voltage is a sum of the reference voltage and two thirds of a rated voltage, the second initial voltage is a sum of the reference voltage and one third of the rated voltage, and the first selected voltage is a sum of the reference voltage and the rated voltage; or, the first initial voltage is a difference obtained by subtracting two thirds of a rated voltage from the reference voltage, the second initial voltage is a difference obtained by subtracting one third of the rated voltage from the reference voltage, and the first selected voltage is a difference obtained by subtracting the rated voltage from the reference voltage.

**19.** The method of data reading for a storage apparatus according to claim 18, wherein the rate voltage comprises a maximum power supply voltage.

**20.** An electronic device, comprising the storage apparatus according to any one of claims 1 to 10.

2

Control module

22 ⌒ Word line selection circuit

21

U ⌒

12 ⌒
13 ⌒
11 ⌒

23

Bit line selection circuit

24

Sense amplifier

X

Y

WL

BL

FIG. 1

Charge integrator — 241

Secondary amplifier — 242

24

FIG. 2

FIG. 3

| Set the voltage of each word line to a first initial voltage, and set the voltage of each bit line to a second initial voltage | S100 |

| Set the voltage of the selected bit line to a first selected voltage, and connect the selected bit line to a sense amplifier | S200 |

| Set the voltage of the selected word line to a second selected voltage | S300 |

| Output, by the sense amplifier, a data read signal on the basis of whether charge transfer has occurred in charges on the bit line, the data read signal being used for representing data stored in the memory units | S400 |

FIG. 4

Set the voltage of each word line to a first initial voltage, and set the voltage of each bit line to a second initial voltage ⌇ S100

↓

Set the voltage of the selected bit line to a first selected voltage, connect the selected bit line to a sense amplifier, and initialize the sense amplifier ⌇ S200

↓

Set the voltage of the selected word line to a second selected voltage ⌇ S300

↓

Output, by the sense amplifier, a data read signal on the basis of whether charge transfer has occurred in charges on the bit line, the data read signal being used for representing data stored in the memory units ⌇ S400

↓

Execute a write recovery operation on the memory units after charge transfer has occurred on the bit line and the sense amplifier outputs the data read signal, so as to to recover the read data in the memory units ⌇ S500

FIG. 5

Measure, by the charge integrator, the total amount of charge flowing into or out of the bit line at the first selected voltage, and convert the total amount of charge into a voltage signal as an initial read signal, after connecting the selected bit line, ⌇ S410

↓

By the secondary amplifier, compare the initial read signal with a reference signal, and output the data read signal according to the result of comparison of the initial read signal and the reference signal ⌇ S420

FIG. 6

## INTERNATIONAL SEARCH REPORT

| International application No. |
|---|
| **PCT/CN2024/121762** |

**A. CLASSIFICATION OF SUBJECT MATTER**

G11C16/08(2006.01)i; G11C16/24(2006.01)i

According to International Patent Classification (IPC) or to both national classification and IPC

**B. FIELDS SEARCHED**

Minimum documentation searched (classification system followed by classification symbols)

IPC:G11C

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 存储, 阵列, 字线, 位线, 读, 写, 电极, 电压, 放大器, storage, array, word, line, bit, read, write, electrode, voltage, amplifier

**C. DOCUMENTS CONSIDERED TO BE RELEVANT**

| Category* | Citation of document, with indication, where appropriate, of the relevant passages | Relevant to claim No. |
|---|---|---|
| PX | CN 118136073 A (BEIJING SUPERSTRING ACADEMY OF MEMORY TECHNOLOGY) 04 June 2024 (2024-06-04) claims 1-10, and description, paragraphs [0063]-[0066] | 1-2, 4-6, 9, 11, 13-15, 18, 20 |
| A | CN 117711466 A (YANGTZE MEMORY TECHNOLOGIES CO., LTD.) 15 March 2024 (2024-03-15) claims 1-16, and description, paragraphs [0079]-[0190] | 1-20 |
| A | CN 116762131 A (HUAWEI TECHNOLOGIES CO., LTD.) 15 September 2023 (2023-09-15) entire document | 1-20 |
| A | CN 116959525 A (HUAWEI TECHNOLOGIES CO., LTD.) 27 October 2023 (2023-10-27) entire document | 1-20 |
| A | US 9837168 B1 (GLOBALFOUNDRIES INC.) 05 December 2017 (2017-12-05) entire document | 1-20 |

☐ Further documents are listed in the continuation of Box C.　☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **12 November 2024** | **19 November 2024** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
**Information on patent family members**

International application No.

**PCT/CN2024/121762**

| Patent document cited in search report | | | Publication date (day/month/year) | Patent family member(s) | | | Publication date (day/month/year) |
|---|---|---|---|---|---|---|---|
| CN | 118136073 | A | 04 June 2024 | None | | | |
| CN | 117711466 | A | 15 March 2024 | US | 2024029793 | A1 | 25 January 2024 |
| | | | | TW | 202406112 | A | 01 February 2024 |
| CN | 116762131 | A | 15 September 2023 | WO | 2022193249 | A1 | 22 September 2022 |
| CN | 116959525 | A | 27 October 2023 | WO | 2023202166 | A1 | 26 October 2023 |
| US | 9837168 | B1 | 05 December 2017 | US | 10026494 | B2 | 17 July 2018 |
| | | | | TW | 201814713 | A | 16 April 2018 |
| | | | | CN | 107833587 | A | 23 March 2018 |
| | | | | TW | 607446 | B1 | 01 December 2017 |

Form PCT/ISA/210 (patent family annex) (July 2022)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 2024121762 W

- CN 202410317881